(19) **Europäisches Patentamt**
**European Patent Office**
**Office européen des brevets**

(11) **EP 1 919 078 A1**

(12) # EUROPEAN PATENT APPLICATION

(43) Date of publication:
**07.05.2008 Bulletin 2008/19**

(51) Int Cl.:
*H03D 7/14* *(2006.01)*

(21) Application number: **06123217.9**

(22) Date of filing: **31.10.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(71) Applicant: **CSEM Centre Suisse d'Electronique et de**
**Microtechnique SA Recherche et Développement**
**2007 Neuchâtel (CH)**

(72) Inventors:
• **GERRITS, John F. M.**
**2016, Cortaillod (CH)**
• **FARSEROTU, John R.**
**2000, Neuchâtel (CH)**

(74) Representative: **GLN**
**Rue du Puits-Godet 8a**
**2000 Neuchâtel (CH)**

(54) **Sub-carrier filter and demodulator for FM-UWB receivers**

(57)     The present invention relates to a sub-carrier filter and demodulator for a wireless communication receiver, comprising two mixers (10) each connected to receive a same sub-carrier signal ($V_x$) and respectively driven by two quadrature signals produced by a local oscillator (11) and to apply down-converted signals to respective low-pass filters before they are fed into a digital FSK demodulator circuit, wherein said mixers (10) are driven by triangular wave signals (LOI,LOQ) and comprise:
- a first differential pair of transistors (24-25) having bipolar characteristics, for converting said sub-carrier signal ($V_x$) into two currents ($I_1,I_2$), and
- second and third pairs of transistors (16-18,17-19) having bipolar characteristics, for respectively multiplying said currents ($I_1,I_2$) with said triangular wave signals (LOI, LOQ) and applying them to said low-pass filters (12).
Application to UWBFM for reducing harmonics in mixers for downconversion.
Mixers are implementable as Gilbert cells.

Fig. 4

EP 1 919 078 A1

**Description**

The present invention relates to a sub-carrier filter and demodulator circuit for use in a in a wireless communication receiver such as a FM-Ultra Wide Band (UWB) receiver.

Ultra Wide Band communication systems are playing an increasingly important role in today's short-range communication systems, especially in Personal Area Network (PAN) applications.

FM-UWB is based upon a low modulation index digital frequency shift keying (FSK) followed by a high modulation index analog frequency modulation (FM) to create a constant envelope UWB signal with flat power spectral density and steep spectral roll-off. Different users may use the same center frequency ($f_C$), and distinguish themselves by their sub-carrier frequency ($f_{SUB}$), that is typically in the 1 - 2 MHz range.

The FM-UWB receiver comprises a Low Noise Amplifier (LNA) followed by a wideband FM demodulator, a low-frequency sub-carrier filter and amplification stages, and a sub-carrier filter and demodulator.

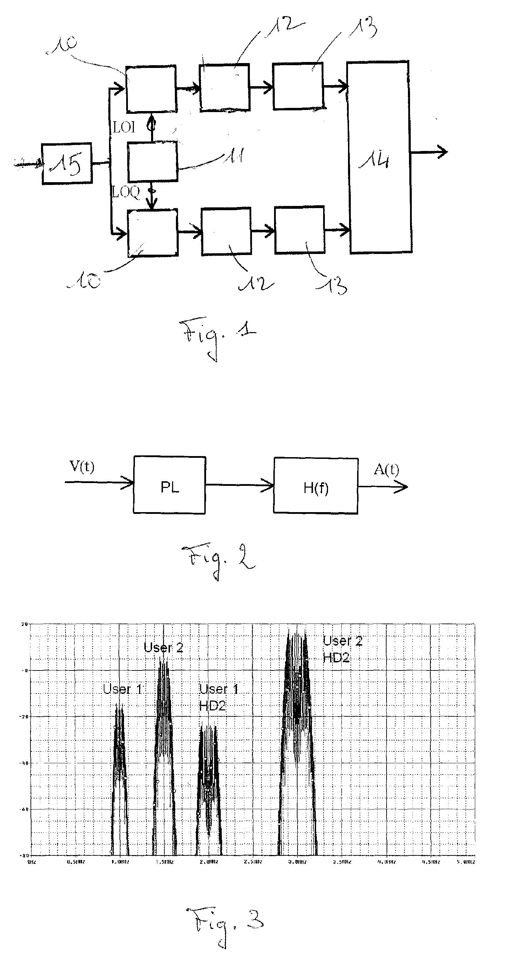

Figure 1 represents the sub-carrier filter and demodulator, a detailed description of which can be found in US Patent N° 4 462 107. As shown 1, the sub-carrier signals are first down-converted by two mixers 10, e.g. double-balanced Gilbert mixers, driven by two square wave quadrature signals LOI (in phase) and LOQ (in quadrature) produced by a local oscillator 11. Each mixer is followed by a low-pass filter 12 and an amplifier 13. The amplified signals are next fed into a digital FSK demodulator circuit 14.

An anti-aliasing filter (AAF) 15 is preceding the two mixers 10. This filter reduces the signal bandwidth to the bandwidth occupied by fundamental (1st harmonic) of the sub-carrier signals (1-2 MHz).

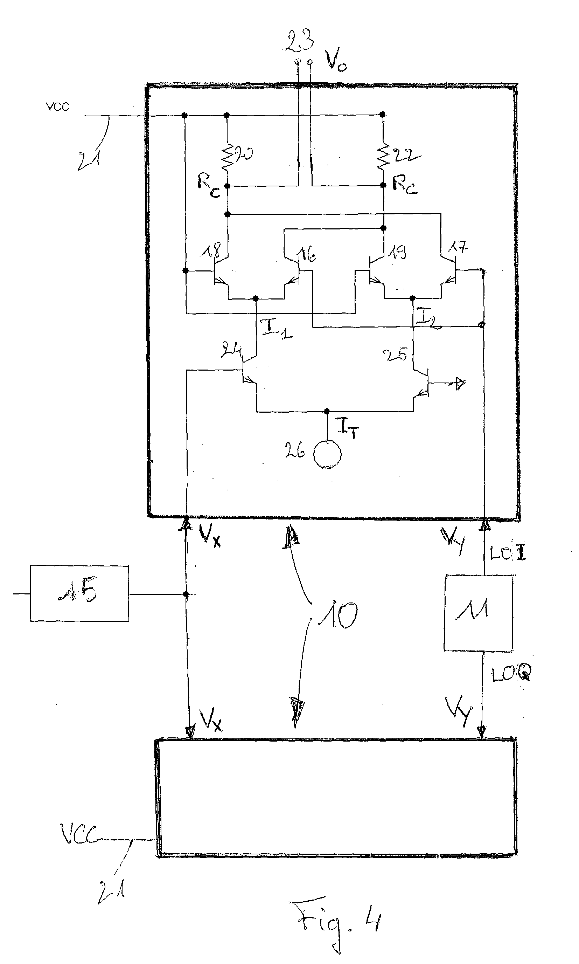

Figure 2 presents a simplified model of the propagation from transmitter to receiver. V(t) is the UWB signal and A(t) the amplitude of the received signal. It is a cascade of a frequency independent part PL representing the path loss and a frequency-dependent channel transfer function H(f) that also includes the transfer function of the antennas. For free space propagation conditions and wideband constant-aperture antennas, $H(f) \approx 1$.

In the case of multipath, the channel transfer function H(f) will not be flat. The UWB signal is scanning this frequency dependent channel transfer function with the rhythm of the modulated sub-carrier signal. The amplitude A(t) of the received UWB signal will vary accordingly. As a result of these amplitude variations, the output signal at the wideband FM demodulator will show harmonic distortion.

For example, in the case of two users with sub-carrier frequencies $f_{SUB1} = 1\mathrm{MHz}$ and $f_{SUB2} = 1{,}5\mathrm{MHz}$, harmonics of an unwanted (different user) sub-carrier signal of frequency $f_{SUB2}$ may coincide with harmonics of the wanted sub-carrier signal with frequency $f_{SUB1}$. When a simple switching mixer with a square wave local oscillator (LO) signal of frequency $f_{SUB1}$ is used, this mixer will also down-convert signals at odd harmonics of the LO frequency. E.g., with $f_{SUB1} = 1$ MHz, signals at 3, 5, 7,.. MHz will also be down-converted.

This is illustrated in Figure 3 showing the result of 2nd harmonic distortion for the two-user case: User 1 and User 2. The 2nd harmonic HD2 of the 1.5 MHz sub-carrier signal arrives at 3 MHz. When the mixers of Figure 1 are switching mixers, this 3 MHz signal will also be down-converted and overlap with the down-converted 1 MHz signal. As a result, this wanted signal will be lost. For the sake of clarity, only 2nd harmonic distortion is shown here. However, higher-order harmonics may also occur.

The AAF filter 15 is intended to attenuate this 2nd harmonic at 3 MHz to a certain extent. However, such a filter suffers from rather severe specifications, making it power hungry and area consuming.

An object of the present invention is to provide a mixer circuit that has built-in harmonic attenuation. As a result, the specifications of the AAF will be relaxed and its power consumption and chip area will remain reasonable.

More precisely, the invention relates to a sub-carrier filter and demodulator of a wireless communication receiver, comprising two mixers each connected to receive a same sub-carrier signal and respectively driven by two quadrature signals produced by a local oscillator and to apply down-converted signals to respective low-pass filters before they are fed into a digital FSK demodulator circuit. According to this invention, the mixers are driven by triangular wave signals and comprise:

- a first differential pair of transistors having bipolar characteristics, for converting the sub-carrier signal into two currents, and
- second and third pairs of transistors having bipolar characteristics, for respectively multiplying said currents with said triangular wave signals and applying them to the low-pass filters.

Other features and objects of this invention will become more apparent by reference to the following description taken in conjunction with Figure 4 which is a block diagram of a preferred embodiment of such a mixer circuit.

Figure 4 shows the two mixers 10 of Figure 1, connected to filter 15 and to local oscillator 11. According to an essential characteristic of the invention, the two quadrature signals LOI (in phase) and LOQ (in quadrature) respectively applied at the inputs $V_y$ of the two mixers 10 are triangular wave signals.

The two mixers 10 being identical, one receiving the LOI signal and the other one the LOQ signal, figure 4 shows the detailed structure of only one of them.

The output of local oscillator 11 is connected to the base of two bipolar transistors 16 and 17. The emitter of transistor 16 is connected, at inputs $V_y$, to the emitter of a bipolar transistor 18, whereas the emitter of transistor 17 is connected to the emitter of a bipolar transistor 19. The collectors of transistors 17 and 18 are connected together, through a resistor 20, to a VCC line 21, whereas the collectors of transistors 16 and 19 are connected together, through a resistor 22, to VCC line 21. The collectors of transistors 17 and 18 and the collectors of transistors 16 and 19 constitute the output 23 of the mixer which delivers an output signal $V_O$ to low-pass filter 12. The bases of transistors 18 and 19 are connected to VCC line 21.

The output of AAF filter 15 is connected, at the inputs $V_x$ of the two mixers 10, to the base of a bipolar transistor 24, the collector of which is connected to the emitters of transistors 16 and 18. The emitter of transistor 24 is connected to the emitter of a bipolar transistor 25, the collector of which is connected to the emitters of transistors 17 and 19. Finally, the base of transistor 25 is connected to earth, whereas the emitters of transistors 24 and 25 are connected to a current source 26.

The above mentioned transistors are bipolar, but they could also, without departing from the spirit of this invention, be of the type having bipolar characteristics, such as MOS transistors operating in weak inversion.

The above described mixer, known as a Gilbert mixer, but driven by triangular wave signals, thus comprises three differential pairs of bipolar transistors as exposed hereafter:

- the pair of transistors 24-25 converts the sub-carrier signal $V_x$ into two currents $I_1$ and $I_2$; and
- the pair of transistors 16-18 and the pair of transistors 17-19 multiply respectively the currents $I_1$ and $I_2$ with the triangular wave signals LOI and LOQ.

The mixers of this invention are characterized by a transfer function which can be shown to be:

$$V_O = I_T R_C \tanh(V_X/2V_T) \tanh(V_Y/2V_T) \approx I_T R_C \tanh(20V_X) \tanh(20V_Y)$$

with:

- $V_O$ : output signal
- $I_T$ : mixer tail current
- $R_c$ : mixer collector resistance
- $V_X$ : input signal
- $V_T$ : thermal voltage
- $V_Y$ : LO signal

Clearly, the hyperbolic tangent function introduces a non-linearity both for the $V_X$ and $V_Y$ inputs. This hyperbolic tangent function can, however, also be exploited for the sake of harmonics attenuation.

Remembering the fact that a single differential pair, also having a hyperbolic tangent transfer, can be used for shaping a triangular wave into a sine wave with low harmonic distortion, this property can be exploited in a mixer to attenuate its sensitivity at harmonics of the LO frequency $f_{LO}$ that may be present in the input signal $V_X$.

The present invention exploits a triangular LO signal of appropriate amplitude at mixer input VY resulting in optimum attenuation of mixer input signal components at odd multiples of the LO frequency. Components at even multiples of the LO frequency are already attenuated due to the symmetry of the circuit.

The amplitude $v_m$ of the LO signal is typically chosen equal to:

$$v_m = \alpha V_T = \alpha (kT/q)$$

with:

- $\alpha$: amplitude normalized to $V_T$
- $V_T$ : thermal voltage
- k: Boltzmann's constant
- T: absolute temperature (K)
- q: elementary charge

At room temperature (293 K), a triangular wave with amplitude $v_m$ = 74 mV ($\alpha$ = 2.93) was found to give best results. The amplitude $v_m$ should be made proportional to absolute temperature (PTAT), which in IC technology is rather straightforward.

Triangular signals are straightforward to generate in IC technology, using either an analog or digital (Direct Digital Synthesis) approach.

The use, in a wireless communication receiver, such as a FM-Ultra Wide Band (UWB) receiver, of mixers built in accordance with the teaching of the present invention offers the following main advantages:

- attenuation of input signals with frequencies equal to odd multiples of the LO frequency ;
- straightforward generation of triangular LO signals using either analog or digital techniques;
- relaxed AAF filters specifications resulting in lower power consumption and reduced chip area for the receiver.

**Claims**

1. Sub-carrier filter and demodulator of a wireless communication receiver, comprising two mixers (10) each connected to receive a same sub-carrier signal ($V_x$) and respectively driven by two quadrature signals produced by a local oscillator (11) and to apply down-converted signals to respective low-pass filters (12) before they are fed into a digital FSK demodulator circuit (14), **characterized in that** said mixers (10) are driven by triangular wave signals (LOI, LOQ) and comprise:

    - a first differential pair of transistors (24-25) having bipolar characteristics, for converting said sub-carrier signal ($V_x$) into two currents ($I_1$, $I_2$), and
    - second and third pairs of transistors (16-18, 17-19) having bipolar characteristics, for respectively multiplying said currents ($I_1$, $I_2$) with said triangular wave signals (LOI, LOQ) and applying them to said low-pass filters (12).

2. Sub-carrier filter and demodulator according to claim 1, wherein said transistors are bipolar, **characterized in that** the duty cycle of said triangular wave signals (LOI, LOQ) is of 50%.

3. Sub-carrier filter and demodulator according to claim 2, **characterized in that** the transfer function of said mixers (10) is expressed by the formula :

$$V_O = I_T R_C \tanh(V_X/2V_T) \tanh(V_Y/2V_T) \approx I_T R_C \tanh(20V_X) \tanh(20V_Y)$$

with:

    - $V_O$ : output signal
    - $I_T$ : mixer tail current
    - $R_c$ : mixer collector resistance
    - $V_X$ : input signal
    - $V_T$ : kT/q thermal voltage
    - $V_Y$ : LO signal

4. Sub-carrier filter and demodulator according to any of claims 2 and 3, **characterized in that** the amplitude $v_m$ of said triangular wave signals (LOI, LOQ) is expressed by the formula

$$v_m = \alpha\, V_T = \alpha\, (kT/q)$$

with:

    - $\alpha$: amplitude normalized to $V_T$
    - $V_T$ : thermal voltage
    - k: Boltzmann's constant
    - T: absolute temperature (K)

- q: elementary charge

Fig. 1

Fig. 2

Fig. 3

Fig. 4

European Patent
Office

**EUROPEAN SEARCH REPORT**

Application Number

EP 06 12 3217

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 560 942 A (JANTA DIETER [DE] ET AL) 24 December 1985 (1985-12-24) * column 1, line 45 - line 55 * * column 2, line 10 - line 21 * * column 5, line 7 - line 9 * * figure 2 * ----- | 1-4 | INV. H03D7/14 |
| A | "RF up/down conversion is simplified by linear arrays - AN9744.1" INTERSIL APPLICATION NOTE, [Online] 1 June 2004 (2004-06-01), pages 1-5, XP002427978 Retrieved from the Internet: URL:http://www.intersil.com/data/an/an9744 .pdf> [retrieved on 2007-04-03] * figure 9 * ----- | 1-4 | |
| A | AYADI, J.; GERRITS, J.; VANEY, P.; FARSEROTU J.: "Ultra-wideband investigations for low data rate wireless Personal Area Network" SETIT 2004, 15 March 2004 (2004-03-15), pages 1-8, XP002427979 Tunisia * paragraph [04.2] * ----- | 1 | TECHNICAL FIELDS SEARCHED (IPC) H03D |

The present search report has been drawn up for all claims

| Place of search | Date of completion of the search | Examiner |
|---|---|---|
| Berlin | 3 April 2007 | Farese, Luca |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**ANNEX TO THE EUROPEAN SEARCH REPORT
ON EUROPEAN PATENT APPLICATION NO.**                EP 06 12 3217

This annex lists the patent family members relating to the patent documents cited in the above-mentioned European search report.
The members are as contained in the European Patent Office EDP file on
The European Patent Office is in no way liable for these particulars which are merely given for the purpose of information.

03-04-2007

| Patent document cited in search report | | Publication date | Patent family member(s) | | Publication date |
|---|---|---|---|---|---|
| US 4560942 | A | 24-12-1985 | DE | 3114761 A1 | 28-10-1982 |
| | | | FR | 2503955 A1 | 15-10-1982 |
| | | | GB | 2100083 A | 15-12-1982 |
| | | | JP | 1499433 C | 29-05-1989 |
| | | | JP | 57180208 A | 06-11-1982 |
| | | | JP | 63047298 B | 21-09-1988 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4462107 A